# EUROPEAN PATENT APPLICATION

(11) **EP 3 312 994 A1**
(43) Date of publication of application: **25.04.2018**
(21) Application number: 16840531.4
(22) Date of filing: 18.02.2016
(51) Int. Cl.: H03K 17/94

(54) **SWITCH CIRCUIT, POWER SOURCE SYSTEM, AND POWER SUPPLY SYSTEM**

(30) Priority: 31.08.2015 CN 201510543592
(71) Applicant: Huawei Technologies Co., Ltd., Longgang District Shenzhen, Guangdong 518129 (CN)
(72) Inventor: ZHANG, Guoqing, Shenzhen, Guangdong 518129 (CN); TANG, Zhuo, Shenzhen, Guangdong 518129 (CN); ZHU, Yang, Shenzhen, Guangdong 518129 (CN)
(74) Representative: Pfenning, Meinig & Partner mbB
(86) International application number: PCT/CN2016/074006
(87) International publication number: WO 2017/036099

(57) **Abstract**

A switch circuit, a power system, and a power supply system are provided. The switch circuit includes: a first input end (111) and a second input end (112) that are configured to connect to a first power source; a third input end (113) and a fourth input end (114) that are configured to connect to a second power source; a switching module (120), including a first switching circuit (121) and a second switching circuit (122); a first isolating circuit (131); and a control module (140), configured to: when the first power source is powered on and powered off, respectively control the first isolating circuit (131) to be conducted and to be disconnected. The first isolating circuit (131) is disposed between the switching module (120) and the input ends of the first power source, so that safety performance of a product can be improved.

## Description

This application claims priority to Chinese Patent Application No. 201510543592.6, filed with the Chinese Patent Office on August 31, 2015, and entitled "SWITCH CIRCUIT, POWER SYSTEM, AND POWER SUPPLY SYSTEM", which is incorporated herein by reference in its entirety.

### TECHNICAL FIELD

Embodiments of the present invention relate to the circuit field, and more specifically, to a switch circuit, a power system, and a power supply system.

### BACKGROUND

With emergence of hybrid power supply of an alternating current (Alternating Current, AC) and a direct current (Direct Current, DC), for example, a high-voltage direct current (high-voltage direct current, HVDC), to improve electricity utilization reliability, two or multiple power source inputs may be designed for a load circuit. Some of the two or multiple power source inputs are AC inputs, and others are DC inputs. The AC and the DC are switched inside a power supply device.

In the prior art, the AC and the DC may be switched in multiple manners. For example, the AC and the DC may be switched by switching between closing and disconnection of two groups of semiconductor switch components and mechanical switch components that are connected in parallel. In this manner, a problem that an existing mechanical switch component (for example, a relay) produces an electric arc and a problem that a semiconductor switch component generates a large amount of heat can be resolved. However, in this manner, there is a problem of current return. That is, a semiconductor component is used to isolate an AC circuit and a DC circuit, and current return is prone to occur when the semiconductor switch component breaks down, and therefore there is a potential risk.

Therefore, it is expected to provide a technology to improve safety while implementing current switching.

### SUMMARY

Embodiments of the present invention provide a switch circuit, a power system, and a power supply system. The switch circuit can improve safety.

According to a first aspect, a switch circuit is provided, including:
a first input end (111) and a second input end (112) that are configured to connect to a first power source;
a third input end (113) and a fourth input end (114) that are configured to connect to a second power source, where the first power source and the second power source are different in terms of at least one of a power source type or a power source voltage;
a switching module (120), including a first switching circuit (121) and a second switching circuit (122), where: the first switching circuit (121) includes a first mechanical switching switch component (102) and a first semiconductor switching switch component (103) that are connected in parallel, and a second mechanical switching switch component (202) and a second semiconductor switching switch component (203) that are connected in parallel; the second switching circuit (122) includes a third mechanical switching switch component (302) and a third semiconductor switching switch component (303) that are connected in parallel, and a fourth mechanical switching switch component (402) and a fourth semiconductor switching switch component (403) that are connected in parallel; the first mechanical switching switch component (102), the second mechanical switching switch component (202), the third mechanical switching switch component (302), and the fourth mechanical switching switch component (402) are switch components that can be physically disconnected or closed; and the first semiconductor switching switch component (103), the first semiconductor switching switch component (103), the first semiconductor switching switch component (103), and the first semiconductor switching switch component (103) are semiconductor switch components;
a first isolating circuit (131), including a first end, a second end, a third end, and a fourth end, where the first end of the first isolating circuit (131) is connected to the first input end (111) of the first power source, the second end of the first isolating circuit (131) is connected to the second input end (112) of the first power source, the third end of the first isolating circuit (131) is connected to one end of the first mechanical switching switch component (102), and the fourth end of the first isolating circuit (131) is connected to one end of the second mechanical switching switch component (202); and
a control module (140), configured to: when the first power source is powered on and the second power source is powered off, control the first isolating circuit (131) and the first switching circuit (121) to be conducted, and control the second switching circuit (122) to be disconnected, so that the first power source is a power supply source of a load circuit; and when the input ends of the second power source are powered on and the input ends of the first power source are powered off, control the first isolating circuit (131) and the first switching circuit (121) to be disconnected, and control the second switching circuit (122) to be conducted, so that the second power source is a power supply source of the load circuit, and when the first switching circuit (121) is short-circuited, a current that flows through the load circuit is prevented from returning, by using the first switching circuit (121), to a side on which the first input end and the second input end are located.

With reference to the first aspect, in a first possible implementation, the first isolating circuit (131) specifically includes a first mechanical isolating switch component (101) and a second mechanical isolating switch component (201), where the first mechanical isolating switch component (101) is located between the first input end (111) and the first mechanical switching switch component (102), the second mechanical isolating switch component (201) is located between the second input end (112) and the first mechanical switching switch component (202), and the first mechanical isolating switch component (101) and the second mechanical isolating switch component (201) are switch components that can be physically disconnected or closed.

With reference to the first aspect and the first possible implementation, in a second possible implementation, the switch circuit further includes a second isolating circuit (132), where the second isolating circuit (132) includes a third mechanical isolating switch component (301) and a fourth mechanical isolating switch component (401), the third mechanical isolating switch component (301) is located between the third input end (113) and the third mechanical switching switch component (302), the fourth mechanical isolating switch component (401) is located between the fourth input end (114) and the fourth mechanical switching switch component (402), and the third mechanical isolating switch component (301) and the fourth mechanical isolating switch component (401) are switch components that can be physically disconnected or closed; and
the control module (140) is specifically configured to:
when the first power source is powered on and the second power source is powered off, control the first isolating circuit (131) and the first switching circuit (121) to be conducted, and control the second isolating circuit (132) and the second switching circuit (122) to be disconnected, so that the first power source is the power supply source of the load circuit, and when the second switching circuit (122) is short-circuited, the current that flows through the load circuit is prevented from returning, by using the second switching circuit (122), to a side on which the third input end and the fourth input end are located; and
when the second power source is powered on and the first power source is powered off, control the first isolating circuit (131) and the first switching circuit (121) to be disconnected, and control the second isolating circuit (132) and the second switching circuit (122) to be conducted, so that the second power source is the power supply source of the load circuit, and when the first switching circuit (121) is short-circuited, the current that flows through the load circuit is prevented from returning, by using the first switching circuit (121), to the side on which the first input end and the second input end are located.

With reference to the first or second possible implementation, in a third possible implementation,
the first mechanical isolating switch component (101) and the second mechanical isolating switch component (201) are relays.

With reference to the second possible implementation, in a fourth possible implementation,
the third mechanical isolating switch component (301) and the fourth mechanical isolating switch component (401) are relays.

With reference to any one of the first aspect, or the first to the fourth possible implementations, in a fifth possible implementation,
when controlling the first switching circuit (121) to be conducted, the control module first controls the first semiconductor switching switch component (103) and the second semiconductor switching switch component (203) to be conducted, and then controls the first mechanical switching switch component (102) and the second mechanical switching switch component (202) to be conducted, so as to rapidly conduct the first switching circuit (121), and prevent the first mechanical switching switch component (102) and the second mechanical switching switch component (202) from producing an electric arc;
when controlling the first switching circuit (121) to be disconnected, the control module first controls the first mechanical switching switch component (102) and the second mechanical switching switch component (202) to be disconnected, and then controls the first semiconductor switching switch component (103) and the second semiconductor switching switch component (203) to be disconnected, so as to prevent the first mechanical switching switch component (102) and the second mechanical switching switch component (202) from producing an electric arc;
when controlling the second switching circuit (122) to be conducted, the control module first controls the third semiconductor switching switch component (303) and the fourth semiconductor switching switch component (403) to be conducted, and then controls the third mechanical switching switch component (302) and the fourth mechanical switching switch component (402) to be conducted, so as to rapidly conduct the second switching circuit (122), and prevent the third mechanical switching switch component (302) and the fourth mechanical switching switch component (402) from producing an electric arc; and
when controlling the second switching circuit (122) to be disconnected, the control module first controls the third mechanical switching switch component (302) and the fourth mechanical switching switch component (402) to be disconnected, and then controls the third semiconductor switching switch component (303) and the fourth semiconductor switching switch component (403) to be disconnected, so as to prevent the third mechanical switching switch component (302) and the fourth mechanical switching switch component (402) from producing an electric arc.

With reference to any one of the first aspect, or the first to the fifth possible implementations, in a sixth possible implementation,
the first input end (111) and the second input end (112) are configured to input an alternating current, and the third input end (113) and the fourth input end (114) are configured to input a direct current; or
the first input end (111) and the second input end (112) are configured to input a first alternating current, and the third input end (113) and the fourth input end (114) are configured to input a second alternating current, where the first alternating current and the second alternating current are different in terms of a power source voltage; or
the first input end (111) and the second input end (112) are configured to input a first direct current, and the third input end (113) and the fourth input end (114) are configured to input a second direct current, where the first direct current and the second direct current are different in terms of a power source voltage.

With reference to any one of the first aspect, or the first to the sixth possible implementations, in a seventh possible implementation,
the first mechanical switching switch component (102), the second mechanical switching switch component (202), the third mechanical switching switch component (302), and the fourth mechanical switching switch component (402) are relays; and
the first semiconductor switching switch component (103), the second semiconductor switching switch component (203), the third semiconductor switching switch component (303), and the fourth semiconductor switching switch component (403) are one of a metal-oxide-semiconductor field-effect transistor MOSFET, an insulated gate bipolar transistor IGBT, a silicon controlled thyristor SCR, or a triode alternating current semiconductor switch TRIAC.

According to a second aspect, a power system is provided, where the power system includes a first power source, a second power source, and the switch circuit according to any one of the first aspect, or the first to the fifth possible implementations of the first aspect; and
the first power source and the second power source are separately connected to the switch circuit, and are configured as power supply sources of the power system.

According to a third aspect, a power supply system is provided, including a load device and the power system according to the second aspect, where the power system is configured to supply power to the load device.

Based on the foregoing technical solutions, in the embodiments of the present invention, the first isolating circuit is disposed between the switching module and the first input end and second input end. Therefore, when the input ends of the second power source are powered on, because there is the first isolating circuit, even if the first switching circuit is short-circuited, a return current cannot reach, by using the first isolating circuit, the side on which the first input end and the second input end are located, so that safety of users/maintenance personnel is ensured, and safety performance of a product is improved.

### BRIEF DESCRIPTION OF DRAWINGS

To describe the technical solutions in the embodiments of the present invention more clearly, the following briefly describes the accompanying drawings required for describing the embodiments of the present invention. Apparently, the accompanying drawings in the following description show merely some embodiments of the present invention, and a person of ordinary skill in the art may still derive other drawings from these accompanying drawings without creative efforts.
FIG. 1 is a schematic block diagram of a switch circuit according to an embodiment of the present invention;
FIG. 2 is a schematic block diagram of a switch circuit according to another embodiment of the present invention;
FIG. 3 is a schematic block diagram of a switch circuit according to another embodiment of the present invention;
FIG. 4 is a schematic block diagram of a switch circuit according to another embodiment of the present invention;
FIG. 5 is a schematic block diagram of a power system according to an embodiment of the present invention; and
FIG. 6 is a schematic block diagram of a power supply system according to an embodiment of the present invention.

### DESCRIPTION OF EMBODIMENTS

The following clearly and completely describes the technical solutions in the embodiments of the present invention with reference to the accompanying drawings in the embodiments of the present invention. Apparently, the described embodiments are a part rather than all of the embodiments of the present invention. All other embodiments obtained by a person of ordinary skill in the art based on the embodiments of the present invention without creative efforts shall fall within the protection scope of the present invention.

It should be understood that, a switch circuit in the embodiments of the present invention may be located inside user equipment, or may be located outside user equipment. The embodiments of the present invention set no limitation thereto.

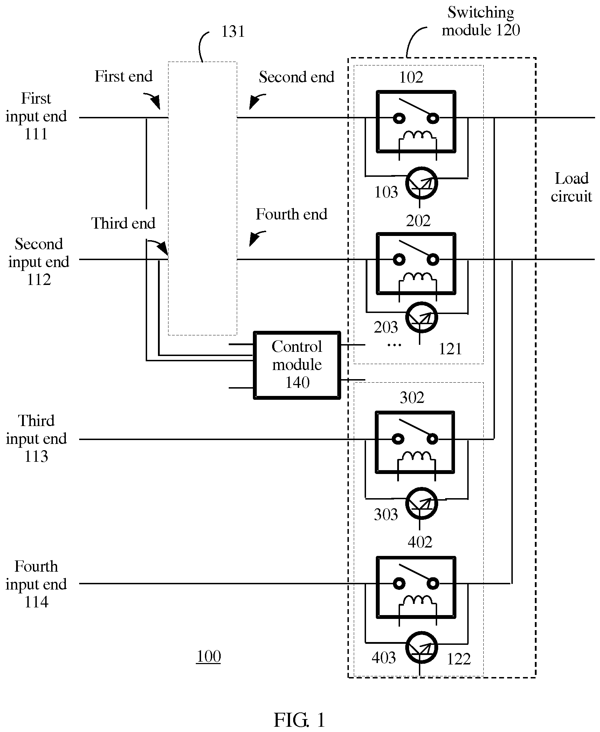

FIG. 1 is a schematic block diagram of a switch circuit 100 according to an embodiment of the present invention. The switch circuit 100 shown in FIG. 1 may include a first input end 111, a second input end 112, a third input end 113, a fourth input end 114, a switching module 120, a first isolating circuit 131, and a control module 140.

Specifically, the switch circuit 100 may include:
the first input end 111 and the second input end 112 that are configured to connect to a first power source;
the third input end 113 and the fourth input end 114 that are configured to connect to a second power source, where the first power source and the second power source are different in terms of at least one of a power source type or a power source voltage;
the switching module 120, including a first switching circuit 121 and a second switching circuit 122, where: the first switching circuit 121 includes a first mechanical switching switch component 102 and a first semiconductor switching switch component 103 that are connected in parallel, and a second mechanical switching switch component 202 and a second semiconductor switching switch component 203 that are connected in parallel; the second switching circuit 122 includes a third mechanical switching switch component 302 and a third semiconductor switching switch component 303 that are connected in parallel, and a fourth mechanical switching switch component 402 and a fourth semiconductor switching switch component 403 that are connected in parallel; the first mechanical switching switch component 102, the second mechanical switching switch component 202, the third mechanical switching switch component 302, and the fourth mechanical switching switch component 402 are switch components that can be physically disconnected or closed; and the first semiconductor switching switch component 103, the first semiconductor switching switch component 103, the first semiconductor switching switch component 103, and the first semiconductor switching switch component 103 are semiconductor switch components;
the first isolating circuit 131, including a first end, a second end, a third end, and a fourth end, where the first end of the first isolating circuit 131 is connected to the first input end 111 of the first power source, the second end of the first isolating circuit 131 is connected to the second input end 112 of the first power source, the third end of the first isolating circuit 131 is connected to one end of the first mechanical switching switch component 102, and the fourth end of the first isolating circuit 131 is connected to one end of the second mechanical switching switch component 202; and
it should be understood that the first isolating circuit 131 may be configured to physically disconnect or close a circuit between the first power source and the first switching circuit 121; and
the control module 140, configured to: when the first power source is powered on and the second power source is powered off, control the first isolating circuit 131 and the first switching circuit 121 to be conducted, and control the second switching circuit 122 to be disconnected, so that the first power source is a power supply source of an electric device; and when the input ends of the second power source are powered on and the input ends of the first power source are powered off, control the first isolating circuit 131 and the first switching circuit 121 to be disconnected, and control the second switching circuit 122 to be conducted, so that the second power source is a power supply source of the electric device, and when the first switching circuit 121 is short-circuited, a current that flows through a load circuit is prevented from returning, by using the first switching circuit 121, to a side on which the first input end and the second input end are located.

Based on the foregoing technical solution, in this embodiment of the present invention, the first isolating circuit is disposed between the switching module and the first power source. Therefore, when the input ends of the second power source are powered on, because there is the first isolating circuit, even if the first switching circuit is short-circuited, a return current cannot reach, by using the first isolating circuit, the side on which the first input end and the second input end are located, so that safety of users/maintenance personnel is ensured, and safety performance of a product is improved.

It should be understood that, because the first input end and the second input end are connected to the first power source, the return current cannot reach a side of the first power source by using the first isolating circuit either, so that the safety of the users/maintenance personnel is ensured, and the safety performance of the product is improved.

It should be noted that, in this embodiment of the present invention, this embodiment of the present invention does not limit a specific form of the first isolating circuit, provided that the first isolating circuit can physically disconnect or close the circuit between the first power source and the first switching circuit 121.

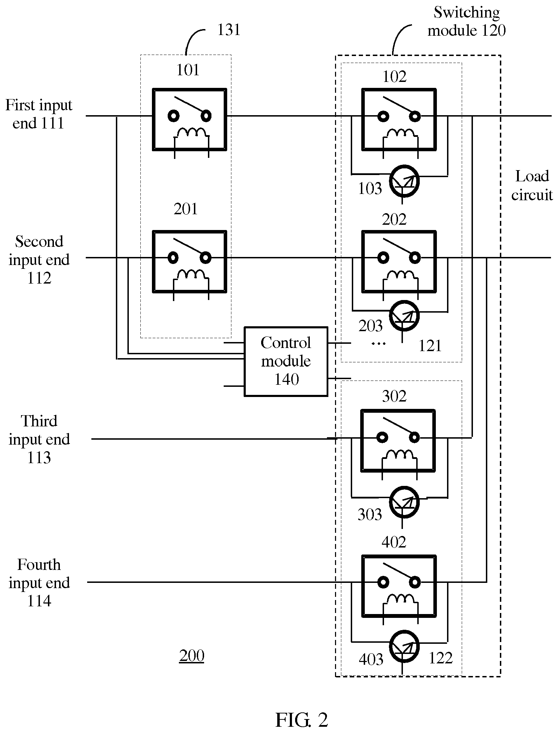

Further, in another embodiment, in a switch circuit 200 shown in FIG. 2,
the first isolating circuit 131 specifically includes a first mechanical isolating switch component 101 and a second mechanical isolating switch component 201, where the first mechanical isolating switch component 101 is located between the first input end 111 and the first mechanical switching switch component 102, the second mechanical isolating switch component 201 is located between the second input end 112 and the first mechanical switching switch component 202, and the first mechanical isolating switch component 101 and the second mechanical isolating switch component 201 are switch components that can be physically disconnected or closed.

In this embodiment of the present invention, the first isolating circuit is disposed between the switching module and the first power source. Therefore, when the input ends of the second power source are powered on, because there is the first isolating circuit, that is, the first isolating circuit is physically disconnected, even if the first switching circuit is short-circuited, a return current cannot reach, by using the first isolating circuit, the side on which the first input end and the second input end are located, so that safety of users/maintenance personnel is ensured, and safety performance of a product is improved.

It should be understood that, in this embodiment of the present invention, the first end of the first isolating circuit 131 may be an input end of the first mechanical isolating switch component 101, the second end may be an output end of the first mechanical isolating switch component 101, the third end may be an input end of the second mechanical isolating switch component 201, and the fourth end may be an output end of the second mechanical isolating switch component 201.

It should be further understood that, in FIG. 2, a same reference numeral is used for an apparatus that is the same as that in FIG. 1. For specific description of the apparatus in FIG. 2 that is the same as that in FIG. 1, refer to related descriptions in FIG. 1. Details are not described herein again, to avoid repetition.

Optionally, the first mechanical switching switch component 102, the second mechanical switching switch component 202, the third mechanical switching switch component 302, and the fourth mechanical switching switch component 402 are relays; and
the first semiconductor switching switch component 103, the second semiconductor switching switch component 203, the third semiconductor switching switch component 303, and the fourth semiconductor switching switch component 403 are one of a metal-oxide-semiconductor field-effect transistor MOSFET, an insulated gate bipolar transistor IGBT, a silicon controlled thyristor SCR, or a triode alternating current semiconductor switch TRIAC.

It should be understood that the first power source and the second power source are different in terms of at least one of a power source type or a power source voltage. In other words, a current input from the first input end and the second input end and a current input from the third input end and the fourth input end are different in terms of a current type or a current voltage.

Correspondingly, in another embodiment, the first input end 111 and the second input end 112 are configured to input an alternating current, and the third input end 113 and the fourth input end 114 are configured to input a direct current.

For example, the third input end 113 and the fourth input end 114 are configured to input a direct current, that is, an HVDC of the second power source.

Alternatively, the first input end 111 and the second input end 112 are configured to input a first alternating current, and the third input end 113 and the fourth input end 114 are configured to input a second alternating current. The first alternating current and the second alternating current are different in terms of a power source voltage.

Alternatively, the first input end 111 and the second input end 112 are configured to input a first direct current, and the third input end 113 and the fourth input end 114 are configured to input a second direct current. The first direct current and the second direct current are different in terms of a power source voltage.

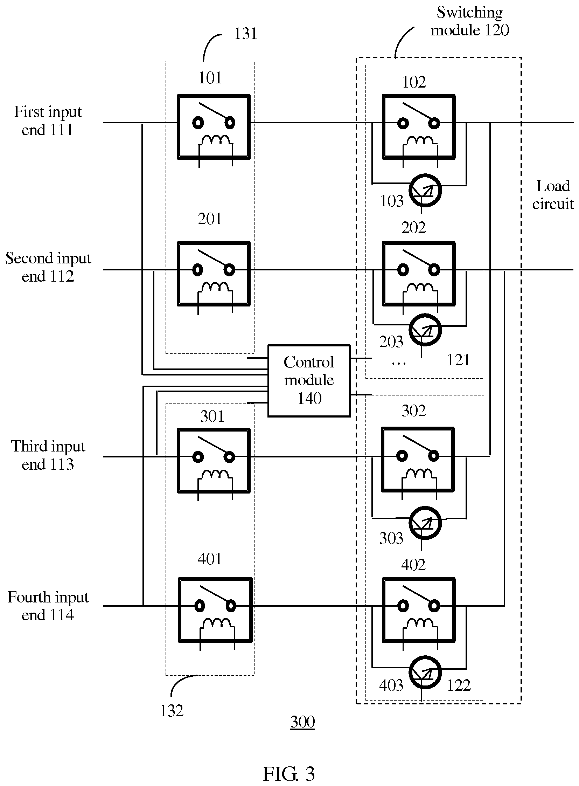

Optionally, in another embodiment, as shown in FIG. 3, a switch circuit 300 further includes a second isolating circuit 132. The second isolating circuit 132 includes a third mechanical isolating switch component 301 and a fourth mechanical isolating switch component 401, the third mechanical isolating switch component 301 is located between the third input end 113 and the third mechanical switching switch component 302, the fourth mechanical isolating switch component 401 is located between the fourth input end 114 and the fourth mechanical switching switch component 402, and the third mechanical isolating switch component 301 and the fourth mechanical isolating switch component 401 are switch components that can be physically disconnected or closed.

The control module 140 is specifically configured to:
when the first power source is powered on and the second power source is powered off, control the first isolating circuit 131 and the first switching circuit 121 to be conducted, and control the second isolating circuit 132 and the second switching circuit 122 to be disconnected, so that the first power source is the power supply source of the electric device, and when the second switching circuit 122 is short-circuited, a current that flows through the load circuit is prevented from returning, by using the second switching circuit 122, to a side on which the third input end and the fourth input end are located; and
when the second power source is powered on and the first power source is powered off, control the first isolating circuit 131 and the first switching circuit 121 to be disconnected, and control the second isolating circuit 132 and the second switching circuit 122 to be conducted, so that the second power source is the power supply source of the electric device, and when the first switching circuit 121 is short-circuited, the current that flows through the load circuit is prevented from returning, by using the first switching circuit 121, to the side on which the first input end and the second input end are located.

Based on the foregoing technical solution, in this embodiment of the present invention, the first isolating circuit is disposed between the switching module and the first power source. Therefore, when the input ends of the second power source are powered on, even if the first switching circuit is short-circuited, because the first isolating circuit is physically disconnected, a return current cannot reach, by using first isolation, the side on which the first input end and the second input end are located. Similarly, the second isolating circuit is disposed between the switching module and the second power source. Therefore, when the input ends of the first power source are powered on, even if the second switching circuit is short-circuited, because there is the first isolating circuit, a return current cannot reach, by using the first isolating circuit, the side on which the third input end and the fourth input end are located. Therefore, safety of users/maintenance personnel is ensured, and safety performance of a product is improved.

Specifically, the control module 140 detects whether there is power input at the first input end 111, the second input end 112, the third input end 113, and the fourth input end 114. If there is power input at an input end, the control module 140 controls a corresponding mechanical switching switch component (101/201/301/401) to be in a "closed" state. For example, the foregoing mechanical switching switch component is a relay. If there is no power input at an input end, the control module 140 controls a relay at this input end to be in an "open" state.

For example, as shown in Table 1, when there is current input at the first input end 111 and the second input end 112 that are connected to the first power source, the first input end 111 and the second input end 112 are on, and the relays 101 and 201 are conducted and in a closed state; or when there is no current input at the first input end 111 and the second input end 112 that are connected to the first power source, the first input end 111 and the second input end 112 are off, and the relays 101 and 201 are disconnected and in an open state. Similarly, when there is current input at the third input end 113 and the fourth input end 114 that are connected to the second power source, the third input end 113 and the fourth input end 114 are on, and the relays 301 and 401 are conducted and in a closed state; or when there is no current input at the third input end 113 and the fourth input end 114 that are connected to the second power source, the third input end 113 and the fourth input end 114 are off, and the relays 301 and 401 are disconnected and in an open state.

**Table 1**

| **State** | | **Control result** | |
|---|---|---|---|
| First input end 111 and second input end 112 | Third input end 113 and fourth input end 114 | 101 and 201 | 301 and 401 |
| On | On | Closed | Closed |
| On | Off | Closed | Open |
| Off | On | Open | Closed |

Therefore, when a single semiconductor switch component in the switching module fails, because the first isolating circuit and the second isolating circuit implement isolation, a hazardous voltage inside a product is isolated without being transmitted outside the product. That is, a risk of current return in the prior art is prevented, so that safety of users/maintenance personnel is ensured, and safety performance is improved.

It should be understood that, in FIG. 3, a same reference numeral is used for an apparatus that is the same as that in FIG. 1 and FIG. 2. For specific description of the apparatus in FIG. 3 that is the same as that in FIG. 1 and FIG. 2, refer to related descriptions in FIG. 1 and FIG. 2. Details are not described herein again, to avoid repetition.

Optionally, in another embodiment, the first mechanical isolating switch component 101, the second mechanical isolating switch component 201, the third mechanical isolating switch component 301, and the fourth mechanical isolating switch component 401 may be relays.

It should be understood that, alternatively, the first mechanical isolating switch component 101, the second mechanical isolating switch component 201, the third mechanical isolating switch component 301, and the fourth mechanical isolating switch component 401 may be other switch components, provided that they can be physically disconnected and closed. This embodiment of the present invention is not limited thereto.

Optionally, in an embodiment, when controlling the first switching circuit 121 to be conducted, the control module first controls the first semiconductor switching switch component 103 and the second semiconductor switching switch component 203 to be conducted, and then controls the first mechanical switching switch component 102 and the second mechanical switching switch component 202 to be conducted, so as to rapidly conduct the first switching circuit 121, and prevent the first mechanical switching switch component 102 and the second mechanical switching switch component 202 from producing an electric arc;
when controlling the first switching circuit 121 to be disconnected, the control module first controls the first mechanical switching switch component 102 and the second mechanical switching switch component 202 to be disconnected, and then controls the first semiconductor switching switch component 103 and the second semiconductor switching switch component 203 to be disconnected, so as to prevent the first mechanical switching switch component 102 and the second mechanical switching switch component 202 from producing an electric arc;
when controlling the second switching circuit 122 to be conducted, the control module first controls the third semiconductor switching switch component 303 and the fourth semiconductor switching switch component 403 to be conducted, and then controls the third mechanical switching switch component 302 and the fourth mechanical switching switch component 402 to be conducted, so as to rapidly conduct the second switching circuit 122, and prevent the third mechanical switching switch component 302 and the fourth mechanical switching switch component 402 from producing an electric arc; and
when controlling the second switching circuit 122 to be disconnected, the control module first controls the third mechanical switching switch component 302 and the fourth mechanical switching switch component 402 to be disconnected, and then controls the third semiconductor switching switch component 303 and the fourth semiconductor switching switch component 403 to be disconnected, so as to prevent the third mechanical switching switch component 302 and the fourth mechanical switching switch component 402 from producing an electric arc.

That is, during power-on, in elements connected in parallel, a semiconductor switch component is powered on first, and then a mechanical switch component is powered on. In this way, rapid power-on is implemented, and the mechanical switch component does not produce an arc. In addition, the semiconductor switch component bears only a transient through-current, but a mechanical switch bears a normally-working through-current. Therefore, the semiconductor switch component does not generate a large amount of heat. During power-off, in elements connected in parallel, a mechanical switch component is powered off first, and then a semiconductor switch component is powered off. In this way, the mechanical switch component does not produce an arc. A switching function is implemented by using the elements connected in parallel, that is, the semiconductor switch component and the mechanical switch component.

The first mechanical switching switch component 102 and the first semiconductor switching switch component 203 that are connected in parallel in the first switching circuit are used as an example. During power-on, the first semiconductor switching switch component 203 is conducted first, and then the first mechanical switching switch component 102 is conducted. A response speed of the first semiconductor switching switch component 203 is faster than that of the first mechanical switching switch component 102. Therefore, when the first semiconductor switching switch component 203 is conducted first, the first switching circuit is rapidly conducted, and no electric arc is produced when the first mechanical switching switch component is connected later. When the first mechanical switch component 102 and the first semiconductor switching switch component 203 are continuously powered in a closed state after being connected, because resistance of the first mechanical switching switch component 102 is less than resistance of the first semiconductor switching switch component 203, most currents are conducted through the first mechanical switch component 102, and only a small quantity of currents are conducted through the first semiconductor switching switch component 203. Therefore, a problem that the first semiconductor switching switch component 203 generates a large amount of heat is avoided. During power-off, the first mechanical switching switch component 102 is powered off first, and then the first semiconductor switching switch component 203 is powered off

, so that the first mechanical switching switch component 102 does not produce an arc.

Therefore, in this embodiment of the present invention, currents can be rapidly switched, and problems that a mechanical switch produces an arc and a semiconductor switch generates a large amount of heat are avoided. Even further, the switch circuit has the first isolating circuit and the second isolating circuit, so that safety performance can be improved.

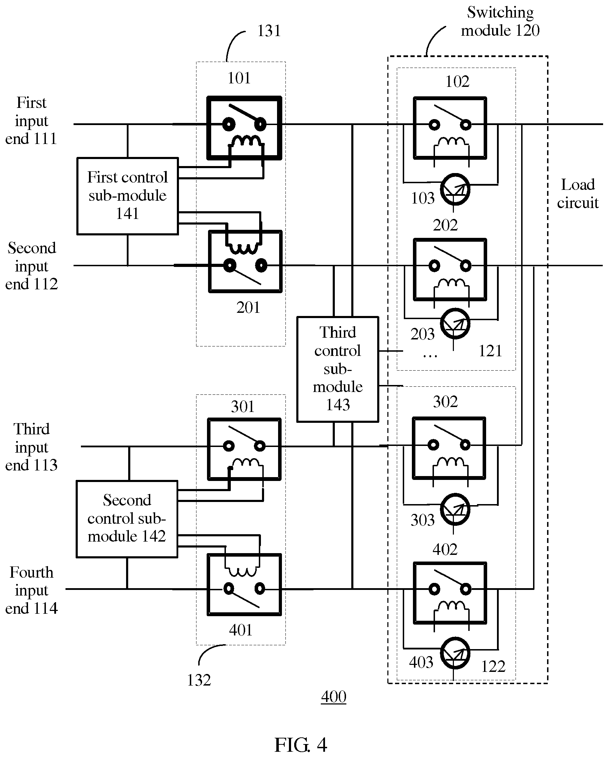

It should be further understood that the foregoing control module in this embodiment of the present invention may include multiple control sub-modules. For example, a control module of a switch circuit 400 shown in FIG. 4 includes a first control sub-module 141, a second control sub-module 142, and a third control sub-module 143. A difference between FIG. 4 and FIG. 1, FIG. 2, and FIG. 3 only lies in that, in FIG. 1, FIG. 2, and FIG. 3, all control circuits are collectively referred to as a control module 140. In FIG. 4, the first control sub-module 141, the second control sub-module 142, and the third control sub-module 143 are collectively referred to as a control module, and can implement functions of the control module 140 in FIG. 1, FIG. 2, and FIG. 3. A first isolating circuit 131, a second isolating circuit 132, and a switching module 120 in FIG. 4 are the same as those described above. Detailed descriptions are properly omitted herein, to avoid repetition.

Specifically, the first control sub-module 141 is configured to: when the first power source is powered on, control the first isolating circuit 131 to be conducted; or when the first power source is powered off, control the first isolating circuit 131 to be disconnected.

The second control sub-module 142 is configured to: when the second power source is powered on, control the second isolating circuit 132 to be conducted; or when the second power source is powered off, control the second isolating circuit 132 to be disconnected.

The third control sub-module 143 is configured to: when the first power source is powered on and the second power source is powered off, control the first switching circuit 121 to be conducted and the second switching circuit 122 to be disconnected; or when the second power source is powered on and the first power source is powered off, control the first switching circuit 121 to be disconnected and the second switching circuit 122 to be conducted.

Specifically, when controlling the first switching circuit 121 to be conducted, the third control sub-module 143 first controls the first semiconductor switching switch component 103 and the second semiconductor switching switch component 203 to be conducted, and then controls the first mechanical switching switch component 102 and the second mechanical switching switch component 202 to be conducted, so as to rapidly conduct the first switching circuit 121, and prevent the first mechanical switching switch component 102 and the second mechanical switching switch component 202 from producing an electric arc;
when controlling the first switching circuit 121 to be disconnected, the third control sub-module 143 first controls the first mechanical switching switch component 102 and the second mechanical switching switch component 202 to be disconnected, and then controls the first semiconductor switching switch component 103 and the second semiconductor switching switch component 203 to be disconnected, so as to prevent the first mechanical switching switch component 102 and the second mechanical switching switch component 202 from producing an electric arc;
when controlling the second switching circuit 122 to be conducted, the third control sub-module 143 first controls the third semiconductor switching switch component 303 and the fourth semiconductor switching switch component 403 to be conducted, and then controls the third mechanical switching switch component 302 and the fourth mechanical switching switch component 402 to be conducted, so as to rapidly conduct the second switching circuit 122, and prevent the third mechanical switching switch component 302 and the fourth mechanical switching switch component 402 from producing an electric arc; and
when controlling the second switching circuit 122 to be disconnected, the third control sub-module 143 first controls the third mechanical switching switch component 302 and the fourth mechanical switching switch component 402 to be disconnected, and then controls the third semiconductor switching switch component 303 and the fourth semiconductor switching switch component 403 to be disconnected, so as to prevent the third mechanical switching switch component 302 and the fourth mechanical switching switch component 402 from producing an electric arc.

It should be understood that, in FIG. 4, a same reference numeral is used for an apparatus that is the same as that in FIG. 1, FIG. 2, and FIG. 3. For specific description of the apparatus in FIG. 4 that is the same as that in FIG. 1, FIG. 2, and FIG. 3, refer to related descriptions in FIG. 1, FIG. 2, and FIG. 3. Details are not described herein again, to avoid repetition.

It should be noted that, the examples in FIG. 1 to FIG. 4 are only intended to help a person skilled in the art understand the embodiments of the present invention rather than restricting the embodiments of the present invention to a specific numerical value or a specific scenario that is illustrated. Apparently, a person skilled in the art can make various equivalent modifications or changes according to the examples given in FIG. 1 to FIG. 4, and such modifications or changes also fall within the scope of the embodiments of the present invention.

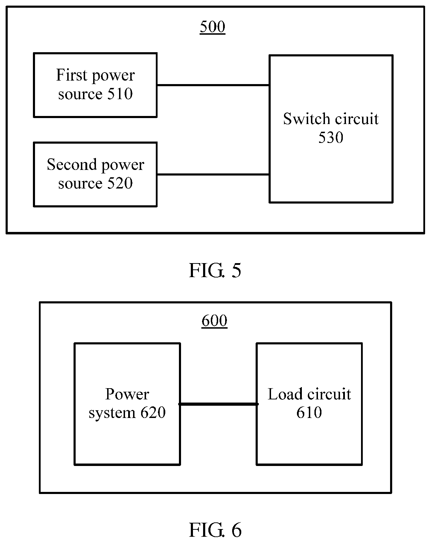

FIG. 5 is a schematic block diagram of a power system according to an embodiment of the present invention. A power system 500 shown in FIG. 5 includes a first power source 510, a second power source 520, and a switch circuit 530 in any one of FIG. 1 to FIG. 4.

The first power source 510 and the second power source 520 are separately connected to the switch circuit 530, and are configured as power supply sources of the power system.

It should be understood that the first power source and the second power source are different in terms of at least one of a power source type or a power source voltage.

It should be understood that the switch circuit 530 in FIG. 5 is corresponding to the switch circuits 100, 200, 300, and 400 in FIG. 1 to FIG. 4. For a specific function of the switch circuit 530, refer to related descriptions of the switch circuits 100, 200, 300, and 400 above. Details are not described herein again, to avoid repetition.

FIG. 6 is a schematic block diagram of a power supply system according to an embodiment of the present invention. A power supply system 600 shown in FIG. 6 includes a load circuit 610 and a power system 620 shown in FIG. 5. The power system 620 is configured to supply power to the load circuit 610.

It should be understood that the power system 620 in FIG. 6 is corresponding to the power system 500 in FIG. 5. For a specific function of the power system 620, refer to corresponding descriptions of the power system 500 above. Details are not described herein again, to avoid repetition.

It should be noted that, the examples in FIG. 4 to FIG. 6 are only intended to help a person skilled in the art understand the embodiments of the present invention rather than restricting the embodiments of the present invention to a specific numerical value or a specific scenario that is illustrated. Apparently, a person skilled in the art can make various equivalent modifications or changes according to the examples given in FIG. 4 to FIG. 6, and such modifications or changes also fall within the scope of the embodiments of the present invention.

A person of ordinary skill in the art may be aware that, in combination with the examples described in the embodiments disclosed in this specification, method steps and units may be implemented by electronic hardware, computer software, or a combination thereof. To clearly describe the interchangeability between the hardware and the software, the foregoing has generally described steps and compositions of each embodiment according to functions. Whether the functions are performed by hardware or software depends on particular applications and design constraint conditions of the technical solutions. A person of ordinary skill in the art may use different methods to implement the described functions for each particular application, but it should not be considered that the implementation goes beyond the scope of the present invention.

Methods or steps described in the embodiments disclosed in this specification may be implemented by hardware, a software program executed by a processor, or a combination thereof. The software program may reside in a random access memory (RAM), a memory, a read-only memory (ROM), an electrically programmable ROM, an electrically erasable programmable ROM, a register, a hard disk, a removable disk, a CD-ROM, or any other form of storage medium known in the art.

The present invention is described in detail with reference to the accompanying drawings and in combination with the preferred embodiments, but the present invention is not limited thereto. Various equivalent modifications or replacements can be made to the embodiments of the present invention by a person of ordinary skill in the art without departing from the spirit and essence of the present invention, and the modifications or replacements shall fall within the scope of the present invention.

## Claims

1. A switch circuit, comprising:
a first input end (111) and a second input end (112) that are configured to connect to a first power source;
a third input end (113) and a fourth input end (114) that are configured to connect to a second power source, wherein the first power source and the second power source are different in terms of at least one of a power source type or a power source voltage;
a switching module (120), comprising a first switching circuit (121) and a second switching circuit (122), wherein: the first switching circuit (121) comprises a first mechanical switching switch component (102) and a first semiconductor switching switch component (103) that are connected in parallel, and a second mechanical switching switch component (202) and a second semiconductor switching switch component (203) that are connected in parallel; the second switching circuit (122) comprises a third mechanical switching switch component (302) and a third semiconductor switching switch component (303) that are connected in parallel, and a fourth mechanical switching switch component (402) and a fourth semiconductor switching switch component (403) that are connected in parallel; the first mechanical switching switch component (102), the second mechanical switching switch component (202), the third mechanical switching switch component (302), and the fourth mechanical switching switch component (402) are switch components that can be physically disconnected or closed; and the first semiconductor switching switch component (103), the first semiconductor switching switch component (103), the first semiconductor switching switch component (103), and the first semiconductor switching switch component (103) are semiconductor switch components;
a first isolating circuit (131), comprising a first end, a second end, a third end, and a fourth end, wherein the first end of the first isolating circuit (131) is connected to the first input end (111) of the first power source, the second end of the first isolating circuit (131) is connected to the second input end (112) of the first power source, the third end of the first isolating circuit (131) is connected to one end of the first mechanical switching switch component (102), and the fourth end of the first isolating circuit (131) is connected to one end of the second mechanical switching switch component (202); and
a control module (140), configured to: when the first power source is powered on and the second power source is powered off, control the first isolating circuit (131) and the first switching circuit (121) to be conducted, and control the second switching circuit (122) to be disconnected, so that the first power source is a power supply source of a load circuit; and when the input ends of the second power source are powered on and the input ends of the first power source are powered off, control the first isolating circuit (131) and the first switching circuit (121) to be disconnected, and control the second switching circuit (122) to be conducted, so that the second power source is a power supply source of the load circuit, and when the first switching circuit (121) is short-circuited, a current that flows through the load circuit is prevented from returning, by using the first switching circuit (121), to a side on which the first input end and the second input end are located.

2. The switch circuit according to claim 1, wherein
the first isolating circuit (131) specifically comprises a first mechanical isolating switch component (101) and a second mechanical isolating switch component (201), wherein the first mechanical isolating switch component (101) is located between the first input end (111) and the first mechanical switching switch component (102), the second mechanical isolating switch component (201) is located between the second input end (112) and the first mechanical switching switch component (202), and the first mechanical isolating switch component (101) and the second mechanical isolating switch component (201) are switch components that can be physically disconnected or closed.

3. The switch circuit according to claim 1 or 2, wherein
the switch circuit further comprises a second isolating circuit (132), wherein the second isolating circuit (132) comprises a third mechanical isolating switch component (301) and a fourth mechanical isolating switch component (401), the third mechanical isolating switch component (301) is located between the third input end (113) and the third mechanical switching switch component (302), the fourth mechanical isolating switch component (401) is located between the fourth input end (114) and the fourth mechanical switching switch component (402), and the third mechanical isolating switch component (301) and the fourth mechanical isolating switch component (401) are switch components that can be physically disconnected or closed; and
the control module (140) is specifically configured to:
when the first power source is powered on and the second power source is powered off, control the first isolating circuit (131) and the first switching circuit (121) to be conducted, and control the second isolating circuit (132) and the second switching circuit (122) to be disconnected, so that the first power source is the power supply source of the load circuit, and when the second switching circuit (122) is short-circuited, the current that flows through the load circuit is prevented from returning, by using the second switching circuit (122), to a side on which the third input end and the fourth input end are located; and
when the second power source is powered on and the first power source is powered off, control the first isolating circuit (131) and the first switching circuit (121) to be disconnected, and control the second isolating circuit (132) and the second switching circuit (122) to be conducted, so that the second power source is the power supply source of the load circuit, and when the first switching circuit (121) is short-circuited, the current that flows through the load circuit is prevented from returning, by using the first switching circuit (121), to the side on which the first input end and the second input end are located.

4. The switch circuit according to claim 2 or 3, wherein
the first mechanical isolating switch component (101) and the second mechanical isolating switch component (201) are relays.

5. The switch circuit according to claim 3, wherein
the third mechanical isolating switch component (301) and the fourth mechanical isolating switch component (401) are relays.

6. The switch circuit according to any one of claims 1 to 5, wherein
when controlling the first switching circuit (121) to be conducted, the control module first controls the first semiconductor switching switch component (103) and the second semiconductor switching switch component (203) to be conducted, and then controls the first mechanical switching switch component (102) and the second mechanical switching switch component (202) to be conducted, so as to rapidly conduct the first switching circuit (121), and prevent the first mechanical switching switch component (102) and the second mechanical switching switch component (202) from producing an electric arc;
when controlling the first switching circuit (121) to be disconnected, the control module first controls the first mechanical switching switch component (102) and the second mechanical switching switch component (202) to be disconnected, and then controls the first semiconductor switching switch component (103) and the second semiconductor switching switch component (203) to be disconnected, so as to prevent the first mechanical switching switch component (102) and the second mechanical switching switch component (202) from producing an electric arc;
when controlling the second switching circuit (122) to be conducted, the control module first controls the third semiconductor switching switch component (303) and the fourth semiconductor switching switch component (403) to be conducted, and then controls the third mechanical switching switch component (302) and the fourth mechanical switching switch component (402) to be conducted, so as to rapidly conduct the second switching circuit (122), and prevent the third mechanical switching switch component (302) and the fourth mechanical switching switch component (402) from producing an electric arc; and
when controlling the second switching circuit (122) to be disconnected, the control module first controls the third mechanical switching switch component (302) and the fourth mechanical switching switch component (402) to be disconnected, and then controls the third semiconductor switching switch component (303) and the fourth semiconductor switching switch component (403) to be disconnected, so as to prevent the third mechanical switching switch component (302) and the fourth mechanical switching switch component (402) from producing an electric arc.

7. The switch circuit according to any one of claims 1 to 6, wherein
the first input end (111) and the second input end (112) are configured to input an alternating current, and the third input end (113) and the fourth input end (114) are configured to input a direct current; or
the first input end (111) and the second input end (112) are configured to input a first alternating current, and the third input end (113) and the fourth input end (114) are configured to input a second alternating current, wherein the first alternating current and the second alternating current are different in terms of a power source voltage; or
the first input end (111) and the second input end (112) are configured to input a first direct current, and the third input end (113) and the fourth input end (114) are configured to input a second direct current, wherein the first direct current and the second direct current are different in terms of a power source voltage.

8. The switch circuit according to any one of claims 1 to 7, wherein
the first mechanical switching switch component (102), the second mechanical switching switch component (202), the third mechanical switching switch component (302), and the fourth mechanical switching switch component (402) are relays; and
the first semiconductor switching switch component (103), the second semiconductor switching switch component (203), the third semiconductor switching switch component (303), and the fourth semiconductor switching switch component (403) are one of a metal-oxide-semiconductor field-effect transistor MOSFET, an insulated gate bipolar transistor IGBT, a silicon controlled thyristor SCR, or a triode alternating current semiconductor switch TRIAC.

9. A power system, wherein the power system comprises a first power source, a second power source, and the switch circuit according to any one of claims 1 to 8, wherein
the first power source and the second power source are separately connected to the switch circuit, and are configured as power supply sources of the power system.

10. A power supply system, comprising a load circuit and the power system according to claim 9, wherein the power system is configured to supply power to the load circuit.
